# EUROPÄISCHE PATENTSCHRIFT

(11) **EP 1 212 834 B1**
(45) Veröffentlichungstag und Bekanntmachung des Hinweises auf die Patenterteilung: **03.08.2005**
(21) Anmeldenummer: 00945533.8
(22) Anmeldetag: 18.05.2000
(51) Int. Cl.: H03K 19/00, H03K 3/45, G01F 15/06

(54) **ELEKTRONISCHE SCHALTUNG UND VERFAHREN ZUR SPEICHERUNG VON INFORMATION MIT FERROELEKTRISCHEN FLIPFLOPS**
ELECTRONIC CIRCUIT FOR A METHOD FOR STORING INFORMATION, SAID CIRCUIT COMPRISING FERROELECTRIC FLIPFLOPS
CIRCUIT ELECTRONIQUE POUR PROCEDE DE MEMORISATION D'INFORMATIONS, POURVU DE BASCULES FERROELECTRIQUES

(30) Priorität: 25.08.1999 DE 19940355
(43) Veröffentlichungstag der Anmeldung: 12.06.2002
(73) Patentinhaber: Infineon Technologies AG, 81669 München (DE)
(72) Erfinder: LAUTERBACH, Christl, D-85635 Höhenkirchen-Siegertsbrunn (DE); BRAUN, Georg, D-80339 München (DE); OLLERT, Udo, D-84558 Kirchweidach (DE); WEBER, Werner, D-80637 München (DE)
(74) Vertreter: Viering, Jentschura & Partner
(86) Internationale Anmeldenummer: PCT/DE2000/001607
(87) Internationale Veröffentlichungsnummer: WO 2001/015323

(56) Entgegenhaltungen:
- EP-A- 0 549 519
- US-A- 4 140 013
- US-A- 5 923 184
- SEITZ C L ET AL: "HOT-CLOCK NMOS" CHAPEL HILL CONFERENCE ON VLSI,XX,XX, 1985, Seiten 1-17, XP000603352
- "FUSELESS NON-VOLATILE FERROELECTRIC REDUNDANT WORD AND BIT DECODER" IBM TECHNICAL DISCLOSURE BULLETIN,US,IBM CORP. NEW YORK, Bd. 34, Nr. 7B, 1. Dezember 1991 (1991-12-01), Seiten 138-140, XP000282528 ISSN: 0018-8689

## Beschreibung

Die vorliegende Erfindung betrifft elektronische Schaltungen mit ferroelektrischen Flipflops, die als einzige Energiequelle eingehende Signale verwenden kann, einen auf einer solchen elektronischen Schaltung basierenden Flüssigkeitszähler, ein Verfahren zur Speicherung von in Signalen enthaltenen Informationen, sowie die Verwendung ferroelektrischer Flipflops für elektronische Schaltungen.

Bei herkömmlichen elektronischen Schaltungen zur Verarbeitung von Signalen, beispielsweise von Zählimpulsen, wird eine Versorgungsspannung benötigt, mit der die Logikbausteine versorgt werden. Diese Versorgungsspannung wird beispielsweise von einer Batterie, wie einer Lithiumbatterie, geliefert. Eine Batterie erhöht die Herstellungs- und Betriebskosten eines die Schaltung verwendenden Geräts erheblich und muß außerdem in regelmäßigen Abständen ersetzt werden. Sollen Ergebnisse einer Signalauswertung auch bei Betriebsspannungsausfall gespeichert bleiben, wird zusätzlich ein nichtflüchtiger Speicher, beispielsweise EEPROM oder FLASH-EPROM benötigt. Solche elektrisch löschbaren Speicherzellen benötigen zur Programmierung und zum Löschen hohe Spannungen von minus 12 beziehungsweise plus 16 Volt, die aus der Batteriespannung durch Ladungspumpen erzeugt werden müssen. Der relativ schlechte Wirkungsgrad bei der Hochvolterzeugung führt zu einer hohen Verlustleistung. Darüber hinaus haben EEPROM-Speicher eine durch die Anzahl von Umprogrammierungen begrenzte Lebensdauer. Dies ist besonders bei Zählschaltungen von Nachteil, wo das sogenannte "Least Significient Bit" (das am wenigsten signifikante Bit oder die kleinste Stelle des Zählers) bei jedem eingehenden Zählimpuls umprogrammiert werden muß.

Gerade bei Geräten, die über längere Zeiträume oder/und an abgelegenen Einsatzorten in Betrieb sein sollen, führt die Abhängigkeit von einer Versorgungsspannung zudem zu einem deutlich erhöhten Wartungsaufwand, da eigens zum Batterietausch beziehungsweise der Batteriekontrolle Wartungspersonal die Geräte aufsuchen muß.

Die Verwendung einer aus dem Stromnetz erzeugten Versorgungsspannung ist ebenfalls mit einem hohen Aufwand verbunden und bei abgelegenen Standorten teilweise gar nicht praktikabel. Bei Netzausfällen kann sie zudem zu falschen Zählergebnissen führen.

Auf Grund der genannten Nachteile besteht jedoch ein Bedürfnis, Schaltungen zu realisieren, die von den oben genannten verschiedenen Spannungsversorgungen soweit als möglich unabhängig operieren können.

In EP 0 549 519 A1 ist eine Vorrichtung zur Registrierung einer Manipulation eines mechanischen Teils beschrieben, bei dem die Stromversorgung der elektronischen Schaltung mittels eines piezoelektrischen Sensors bereitgestellt wird. Wird das mechanische Teil manipuliert, so wird ein Verformmechanismus ausgelöst, der das Piezoelement verformt. Das Piezoelement ist mit einem Speicherelement elektrisch so verbunden, dass der durch die Verformung erzeugte elektrische Impuls die im Speicherelement enthaltene Information verändert. Ferner ist aus US 5 923 184 eine elektronische Schaltung bekannt zur Bereitstellung von Logik-Funktionen, wobei die Schaltung ferroelektrische Transistoren und MOS-Feldeffekttransistoren aufweist.

Der vorliegenden Erfindung liegt somit die Aufgabe zugrunde, eine signalverarbeitende beziehungsweise informationsspeichernde Schaltung bereitzustellen, die von externen Stromversorgungen autark betrieben werden kann.

Diese Aufgabe löst die vorliegende Erfindung durch die Bereitstellung einer elektronischen Schaltung gemäß dem unabhängigen Patentanspruch 1, eines Verfahrens zur Informationsspeicherung gemäß dem unabhängigen Patentanspruch 15 sowie dem Flüssigkeitszähler gemäß dem Patentanspruch 20. Weitere vorteilhafte Ausgestaltungen, Details und Aspekte der vorliegenden Erfindung ergeben sich aus den abhängigen Patentansprüchen, der Beschreibung und den beigefügten- Zeichnungen.

Bei der Analyse signalverarbeitender Schaltungen und der ihnen zugeordneten signalerzeugenden Sensoren wurde nunmehr herausgefunden, daß die den Signalen inhärente Energie zwar nicht ausreicht, um EEPROM-Speicher betreiben zu können, jedoch diese Energie bei einem typischen Impulsdrahtsensor immerhin noch 30 nJ beträgt. Es wurde unerwarteterweise herausgefunden, daß diese Energiemenge ausreichend ist, um Schaltungen zu betreiben, wenn spezielle Flipflops mit implementierten ferroelektrischen Speicherkapazitäten, sogenannte Ferroflipflops, verwendet werden.

Die vorliegende Erfindung ist daher gerichtet auf eine elektronische Schaltung, die aufweist:
einen Eingang zur Eingabe von zumindest einem Informationssignal;
ein Energiemittel zur Umwandlung von im zumindest einen Informationssignal enthaltener Energie in eine Spannungsversorgung;
ein Kontrollmittel zur Erzeugung zumindest eines Einschaltkontrollsignals beim Eingehen eines Informationssignals; sowie
ein Signalverarbeitungsmittel zur Speicherung einer durch das zumindest eine Informationssignal repräsentierten Information und/oder zur Auswertung einer durch das zumindest eine Informationssignal repräsentierten Information und Speicherung der durch die Auswertung erhaltenen Sekundärinformation mittels zumindest einem ferroelektrischen Flipflop;
wobei das Signalverarbeitungsmittel durch das zumindest eine Einschaltkontrollsignal zur Auswertung und/oder Speicherung aktivierbar ist;
und wobei während der Auswertung und/oder Speicherung das zumindest eine Informationssignal die einzige Energiequelle für die elektronische Schaltung sein kann oder ist. Um ein koordiniertes Übertragen von in den ferroelektrischen Kondensatoren der ferroelektrischen Flipflops enthaltenen Information auf die Logikgatter des ferroelektrischen Flipflops zu gewährleisten, weist das Einschaltkontrollsignal folgende Signale auf:
ein Aktivierungssignal zur Aktivierung von Vorladungstransistoren des zumindest einen ferroelektrischen Flipflops;
ein Ubertragungssignal zur Übertragung der in ferroelektrischen Kondensatoren des zumindest einen ferroelektrischen Flipflops enthaltenden Information auf interne Datenleitungen des zumindest einen ferrolektrischen Flipflops; und
ein Stromschaltsignal zum Einschalten der Spannungsversorgung des Signalverarbeitungsmittels.

Eine elektronische Schaltung kann also auch über eine externe Spannungsversorgung verfügen. Maßgeblich ist jedoch, daß sie auf diese für den Informationssignalerfassungsvorgang nicht angewiesen ist. Auch bei einem Stromausfall kann die erfindungsgemäße elektronische Schaltung ihre Funktion weiter ausführen. Bezüglich der Stromversorgung ist die elektronische Schaltung also als eine Fail-Safe-Schaltung aufzufassen. In besonderen Ausführungsformen und besonders bevorzugten Ausführungsformen der vorliegenden Erfindung wird jedoch die elektronische Schaltung überhaupt nicht über eine externe Stromversorgung verfügen, soweit diese nicht zum Auslesen der gespeicherten Informationen angeschlossen wird.

Die erfindungsgemäß verwendeten ferroelektrischen Flipflops werden weiter unten detailliert beschrieben werden. Diese weisen grundsätzlich die gleiche Struktur auf wie konventionelle Flipflops, haben also insbesondere einen SET und einen RESET-Eingang, sowie einen QB- und Q-Ausgang und NAND- oder NOR-Gatter zur Schaltungslogik. Sie verfügen jedoch zusätzlich über ferroelektrische Kondensatoren, die sie in die Lage versetzen, den logischen Zustand des Flipflops beim Abschalten der Spannungsversorgung zu speichern und beim Einschalten der Spannungsversorgung den gespeicherten Zustand wiederherzustellen. Zur Speicherung beziehungsweise Wiederherstellung des Zustands des ferroelektrischen Flipflops werden Kontrollsignale in einer zeitlich genauen definierten Abfolge gegeben (siehe unten). Nichtflüchtige Speicher auf Basis von ferroelektrischen Kondensatoren können bei niedrigen Spannungen betrieben werden und benötigen nur etwa ein Hundertstel der Energie von EEPROM-Speichern. Bei der erfindungsgemäßen elektronischen Schaltung ist es daher möglich, die zum Betrieb einer üblichen Schaltung notwendige Energie (10 nJ bis 100 nJ) allein aus dem eingehenden Impuls oder den eingehenden Impulsen zu entnehmen.

Das Kontrollmittel muß also gemäß der Erfindung in der Lange sein, ein oder mehrere Kontrollsignale in einer zeitlich gesteuerten Abfolge zu generieren und diese dem Signalverarbeitungsmittel zuzuführen. Dieses Ziel kann mit Fachleuten bekannten Schaltungen beziehungsweise Verfahren in einfacher Weise erreicht werden. Beispielsweise können verschiedene zeitlich gestaffelte Signale durch eine Band-Gap-DifferenzSchaltung mit einer Komparator-Schaltung erreicht werden.

Unter einer Auswertung ist im Sinne der vorliegenden Erfindung jegliche Interpretation eines eingegangenen Informationssignals durch das Signalverarbeitungsmittel zu verstehen, beispielsweise die Feststellung eines zeitlichen Abstands zu einem vorausgegangenen Informationssignals, die logische Verknüpfung über UND, ODER, NICHT UND, und NICHT ODER verschiedener Informationssignale, das Auf- und Abzählen von hintereinander eingehenden Informationssignalen und das Hin- und Herschalten zwischen Ein und Aus bei sukzessiven Eingehen von Informationssignalen sowie jegliche andere vorstellbare Interpretation eingehender Informationssignale. Unter einer repräsentierten Information im Sinne der vorliegenden Erfindung ist jegliche Bedeutung zu verstehen, die man dem Eingang eines Informationssignals im zeitlichen Verlauf in seiner spezifischen Ausprägung und in seinem Verhältnis zu anderen Informationssignalen zumessen kann.

Die eingehenden Informationssignale können beispielsweise von einem üblichen Sensor erzeugt worden sein. Vorzugsweise handelt es sich dabei um Sensoren, die ein Signal mit geeigneter Spannung und mit hinreichendem Energiegehalt erzeugen, um die erfindungsgemäße Schaltung betreiben zu können. Beispielsweise können induktive oder piezoelektrische Sensoren verwendet werden. Eine Möglichkeit für einen verwendbaren Sensor ist ein Impulsdrahtsensor, bei dem ein äußeres Magnetfeld, das beispielsweise von einem mit Magneten versehenen Rotor, auf einen Verbunddraht einwirkt und in diesem einen elektrischen Impuls generiert, der dann als Informationssignal zur Verfügung steht. Hierbei wird die gesamte notwendige Energie aus dem Magnetfeld entnommen, so daß auch für den Sensor keine externe Engergieversorung notwendig ist.

Vorzugsweise ist die erfindungsgemäße elektronische Schaltung dadurch gekennzeichnet, daß durch das Kontrollmittel zumindest ein Ausschaltkontrollsignal nach Ablauf einer vorbestimmten Zeit nach Eingehen des zumindest einen Informationssignals und/oder bei Erschöpfung der aus dem zumindest einen Informationssignal umgewandelten Energie erzeugbar ist, wobei das Signalverarbeitungsmittel durch das zumindest eine Ausschaltkontrollsignal zur Speicherung und zum Deaktivieren verahlassbar ist oder veranlasst wird.

Es versteht sich, daß ein Ausschaltkontrollsignal nach Zeitablauf nur dann erzeugt werden soll, wenn nach dem Eingehen eines Informationssignals kein weiteres Informationssignal eingegangen ist. Der Ablauf einer vorbestimmten Zeit bezieht sich also stets auf den Ablauf nach Eingang des letzten Informationssignals, sofern mehrere Informationssignale nacheinander eingegangen sind. Wird das Ausschaltkontrollsignal bei Erschöpfung der vorhandenen Energie erzeugt, muß eine Schaltung im Kontrollmittel vorgesehen sein, die zuverlässig das Erschöpfen dieser Energie feststellen kann. Beispielsweise ist es möglich eine Schaltung zu verwenden, die einen eventuellen Spannungsabfall wahrnehmen kann.

Vorzugsweise ist die in dem zumindest einen ferroelektrischen Flipflop gespeicherte Information durch das Signalverarbeitungsmittel in zumindest ein Ausgangssignal umwandelbar, wobei die elektronische Schaltung dann weiterhin zumindest einen Ausgang zur Ausgabe des zumindest einen Ausgangssignals aufweist. Auf diese Weise läßt sich die in der Schaltung gespeicherte Information wieder durch ein geeignetes Auslesemittel auslesen.

Die elektronische Schaltung kann weiterhin ein Anzeigemittel zur Anzeige der in dem zumindest einen ferroelektrischen Flipflop gespeicherten Information aufweisen. Ein solches zusätzliches Anzeigemittel ist dann möglich, wenn genügend Energie zu seinem Betrieb aus dem Informationssignal gewonnen werden kann. Ein Anzeigemittel ermöglicht die jederzeitige Ablesung der in dem zumindest einen Flipflop gespeicherten Information.

Vorzugsweise wird das Anzeigemittel von der durch das Energiemittel erzeugten Spannungsversorgung mitversorgt. Es ist jedoch auch möglich, das Anzeigemittel so auszugestalten, daß es eine externe Spannungsversorgung benötigt. In diesem Fall muß bei einem autarken Betrieb der elektronischen Schaltung vor dem Ablesen des Anzeigemittels zunächst eine externe Spannungsversorgung angeschlossen werden. Weist die elektronische Schaltung ohnedies eine externe Spannungsversorgung auf, beispielsweise beim oben beschriebenen Einsatzgebiet von Fail-Safe-Schaltungen, wird ein solcher externer Anschluß in der Regel nicht notwendig sein.

Um den Energieverbrauch des Anzeigemittels möglichst gering zu halten, wird bevorzugterweise eine LCD-Anzeige die Informationen anzeigen. Es ist jedoch auch möglich, andere Anzeigen zu verwenden, wenn diese eine hinreichend geringe Energieaufnahme aufweisen.

Um ein Zurückschreiben der in den zumindest einen ferroelektrischen Flipflop enthaltenen Informationen beim Spannungsabfall zu gewährleisten, weist das Auschaltkontrollsignal vorzugsweise folgende Signale auf:
ein Übertragungsendesignal;
ein Aktivierungssignal zur Aktivierung von Vorladungstransistoren des zumindest einen ferroelektrischen Flipflops; und
ein Stromausschaltsignal zum Ausschalten der Spannungsversorgung des Signalverarbeitungsmittels.

Die Übertragung dieser verschiedenen Signale vom Kontrollmittel zum Signalverarbeitungsmittel erfolgt vorzugsweise dadurch, daß vom Kontrollmittel Signalleitungen für jedes der Einschaltsignale beziehungsweise der Ausschaltsignale zum Signalverarbeitungsmittel führen. Beispielsweise kann zudem für das Übertragungssignal und das Übertragungsendesignal eine gemeinsame Übertragungssignalleitung vom Kontrollmittel zum Signalverarbeitungsmittel führen, wobei das Übertragungssignal im Anlegen einer Spannung an die gemeinsame Ubertragungssignalleitung bestehen kann und das Übertragungsendesignal im Abschalten der Spannung an der gemeinsamen Übertragungssignalleitung.

Genauso können für das Stromschaltsignal und Stromausschaltsignal eine gemeinsame Stromsignalleitung vom Kontrollmittel zum Signalverarbeitungssignal führen, wobei das Stromschaltsignal im Anlegen einer Spannung an die gemeinsame Stromsignalleitung besteht und das Stromausschaltsignal im Abschalten der Spannung an der gemeinsamen Stromsignalleitung.

Da mit Flipflops im Allgemeinen Zählschaltungen sehr einfach zu realisieren sind, ist es eine bevorzugte Ausführungsform der vorliegenden Erfindung, daß die Signalverarbeitungsschaltung eine Zählschaltung zur Auswertung einer Mehrzahl von hintereinander oder gleichzeitig eingehenden Informationssignalen durch Zählung der eingegangenen Informationssignale ist. Hier können also ein oder mehrere Informationssignalleitungen gleichzeitig bedient werden, sofern die Schaltung dazu in der Lage ist. Es handelt sich dann um einen Eingangssignalbus.

Die Zählschaltung besteht beispielsweise aus einer Mehrzahl von hintereinander geschalteten, flankengesteuerten ferroelektrischen Flipflops, bei denen das zumindest eine Informationssignal in den Takteingang des ersten ferroelektrischen Flipflops der Mehrzahl von hintereinander geschalteten ferroelektrischen Flipflops eingegeben ist, und der Ausgang von jedem der ferroelektrischen Flipflops bis auf das letzte jeweils auch mit dem Takteingang des dahintergeschalteten ferroelektrischen Flipflops verbunden ist.

Es handelt sich hierbei also um eine übliche Zählerschaltungsanordnung von Flipflops, bei denen allerdings statt der herkömmlicherweise verwendeten Flipflops ferroelektrische Flipflops zum Einsatz kommen.

Die Erfindung ist auch gerichtet auf ein Verfahren zur Speicherung von in Informationssignalen enthaltenen Informationen. Bezüglich der Vorteile, Effekte und Wirkungen des Verfahrens wird auf das oben Gesagte vollinhaltlich Bezug genommen und hierauf verwiesen.

Die Erfindung ist also gerichtet auf ein Verfahren zur Speicherung von durch zumindest ein Informationssignal repräsentierter oder durch eine Auswertung des zumindest einen Informationssignals erhaltener Information in zumindest einem ferroelektrischen Flipflop in einem Signalverarbeitungsmittel mit folgenden Schritten:
A: Erzeugen zumindest eines Einschaltkontrollsignals aus einem eingegangenen Informationssignal und Erzeugen einer Spannungsversorgung aus im zumindest einen Informationssignal enthaltener Energie;
B: Aktivieren des Signalverarbeitungsmittels durch das Einschaltkontrollsignal und Anlegen der Spannungsversorgung an das Signalverarbeitungsmittel;
B1: Aktivieren von Vorladungstransistoren des zumindest einen ferroelektrischen Flipflops (26) durch Anlegen einer Spannung;
B2: Deaktivieren der Vorladungstransistoren des zumindest einen ferroelektrischen Flipflops (26) durch Abschalten der Spannung;
B3: Anlegen einer Spannung an ferroelektrische Kondensatoren des zumindest einen ferroelektrischen Flipflops zur Übertragung der in den ferroelektrischen Kondensatoren gespeicherten Information an Logikgatter des zumindest einen ferroelektrischen Flipflops; und
B4: Aktivieren der Spannungsversorgung der Logikgatter des zumindest einen ferroelektrischen Flipflops;
C: Speichern einer durch das zumindest eine Informationssignal repräsentierten Information und/oder Auswerten einer durch das zumindest eine Informationssignal repräsentierten Information und Speichern der durch die Auswertung erhaltenen Sekundärinformation mittels zumindest des einen ferroelektrischen Flipflops;
D: Erzeugen eines Ausschaltkontrollsignals nach Ablauf einer vorbestimmten Zeit nach Eingehen des zumindest einen Informationssignals und/oder bei Erschöpfung der aus dem zumindest einen Informationssignal umgewandelten Energie; und
E: Deaktivieren des Signalverarbeitungsmittels durch das Ausschaltkontrollsignal.

Auch beim erfindungsgemäßen Verfahren stehen daher zwei Möglichkeiten für die Bestimmung des Zeitpunkts der Erzeugung eines Ausschaltkontrollsignals zur Verfügung, nämlich zum einen wiederum die einfache Messung eines Zeitablaufs nach Eingehen eines Informationssignals, zum anderen die Messung der noch zur Verfügung stehenden Energie, die aus dem Informationssignal gewonnen wurde. Letzteres kann beispielsweise mittels Abfall der Spannung ermittelt werden. Auch hier versteht es sich, dass es bei sukzessiven Eingehen mehrerer Informationssignale wünschenswert ist, dass das Verfahren nicht dazu führt, dass unabhängig vom Eingehen weiterer Informationssignale, durch das Ausschalten bedingt, diese nicht mehr erfasst werden können. Vielmehr sollte auch hier Sorge getragen werden, dass jeweils die Messung der verstrichenen Zeit ab dem letzten eingegangenen Informationssignal erfolgt und dass die Zeitmessung beim Eingehen eines neuen Informationssignals neu anläuft.

Unter einem Deaktivieren des Signalverarbeitungsmittels im Sinne des erfindungsgemäßen Verfahrens ist hierbei zu verstehen, daß die in den ferroelektrischen Flipflops enthaltenen schaltlogischen Zustände kontrolliert in die ferroelektrischen Kondensatoren zurückgeschrieben werden, um beim endgültigen Abschalten der Spannungsversorgung den Inhalt sicher gespeichert zu haben.

Schritt B des erfindungsgemäßen Verfahrens weist somit folgende Teilschritte auf:
B1: Aktivieren der Vorladungstransistoren des zumindest einen ferroelektrischen Flipflops durch Anlegen einer Spannung;
B2: Deaktivieren der Vorladungstransistoren des zumindest einen ferroelektrischen Flipflops durch Abschalten der Spannung;
B3: Anlegen einer Spannung an ferroelektrische Kondensatoren des zumindest einen ferroelektrischen Flipflops zur Übertragung der in den ferroelektrischen Kondensatoren gespeicherten Information an Logikgatter des zumindest einen ferroelektrischen Flipflops; und
B4: Aktivieren der Spannungsversorgung der Logikgatter des zumindest einen ferroelektrischen Flipflops.

Durch diese Abfolge von Signalen, die auf Spannungsänderungen beruhen, wird ein zuverlässiges Übertragen der zuvor bereits gespeicherten Informationen auf die Logikgatter des ferroelektrischen Flipflops erreicht.

Auch beim Abschalten des Signalverarbeitungsmittels wird vorzugsweise eine bestimmte Reihenfolge von Schritten eingehalten. Daher kann Schritt E vorzugsweise folgende Teilschritte aufweisen:
E1: Abschalten einer an ferroelektrischen Kondensatoren des zumindest einen ferroelektrischen Flipflops anliegenden Spannung;
E2: Deaktivieren der Spannungsversorgung der Logikgatter des zumindest einen ferroelektrischen Flipflops;
E3: Aktivieren von Vorladungstransistoren des zumindest einen ferroelektrischen Flipflops durch Anlegen einer Spannung; und
E4: Deaktivieren der Vorladungstransistoren des zumindest einen ferroelektrischen Flipflops durch Abschalten der Spannung.

Durch diese Schritte wird der umgekehrte Prozeß durchgeführt, bei dem die an den Logikgattern anliegenden Pegel als zu speichernde Informationen in die ferroelektrischen Kondensatoren zurückgeschrieben werden.

Vorzugsweise enthält die elektronische Schaltung mehrere ferroelektrische Flipflops, wobei das Auswerten in Schritt C eine Summenbildung aus dem durch das Informationssignal repräsentierten Wert und einem bereits in den ferroelektrischen Flipflops gespeicherten Wert beinhaltet.

Vorzugsweise erfolgt die Summenbildung mittels eines Zählvorgangs, bei dem die Mehrzahl von ferroelektrischen Flipflops in einer Zähleranordnung hintereinander geschaltet sind und ein eingehendes Innformationssignal einen Zählerstand der Zähleranordnung um den Wert 1 erhöht oder erniedrigt.

Eine solche Erhöhung bzw. Erniedrigung um den Wert 1 kommt natürlich nur in Frage, wenn lediglich ein Eingang für ein Informationssignal vorhanden ist. Beim möglichen gleichzeitigen Eingehen oder nacheinander Eingehen mehrerer Informationssignale über verschiedene Eingänge muß der Wert entsprechend erhöht oder erniedrigt werden.

Die in dem zumindest einen ferroelektrischen Flipflop gespeicherte Information kann beispielsweise in zumindest ein Ausgangssignal umgewandelt und aus der elektronischen Schaltung ausgegeben werden. Dieser zusätzliche Verfahrensschritt stellt sicher, daß die durch die Informationssignale gewonnene Information auch tatsächlich einem Anwender zur Verfügung gestellt werden kann.

Unter einem Flüssigkeitszähler wird in der vorliegenden Erfindung ein Gerät verstanden, das in der Lage ist, den Durchfluß einer Flüssigkeit durch einen Querschnitt, beispielsweise ein Rohr oder eine Rinne, zu bestimmen und die gesamte ab einem Startzeitpunkt durch den Querschnitt hindurchgeflossene Flüssigkeitsmenge aufzusummieren. Flüssigkeitszähler müssen häufig über lange Zeiträume am Ort des Einbaus verbleiben, ohne daß sie über eine externe Stromversorgung verfügen können. Hier ist also ein besonders interessantes Anwendungsbeispiel für die vorliegende Erfindung, da bisherige elektrische Flüssigkeitszähler den Austausch von Batterien benötigten.

Demzufolge ist die Erfindung schließlich auch gerichtet auf einen Flüssigkeitszähler zur Bestimmung des Durchflusses von Flüssigkeiten durch eine System, welches aufweist: einen Sensor, der in Abhängigkeit einer durch das System hindurchströmenden Flüssigkeitsmenge, Informationssignale generieren kann oder generiert; und eine erfindungsgemäß aufgebaute elektronische Schaltung zur Zählung der vom Sensor generierten Informationssignale, wobei die Informationssignale die einzige Energiequelle für die elektronische Schaltung sind.

Im folgenden soll die Erfindung an allgemeinen Ausführungsbeispielen erläutert und im einzelnen dargestellt werden, wobei auf die beigefügten Zeichnungen Bezug genommen wird, in den folgendes dargestellt ist:
- Figur 1: zeigt in schematisierter Darstellung eine Ausführungsform der elektronischen Schaltung gemäß der vorliegenden Erfindung;
- Figur 2: zeigt eine weitere Ausführungsform einer elektronischen Schaltung gemäß der vorliegenden Erfindung, bei der zusätzlich eine Anzeigeneinheit vorgesehen ist;
- Figur 3: zeigt einen in der folgenden Erfindung verwendetes ferroelektrisches Flipflop mit nur NOR-Gattern;
- Figur 4: zeigt ein weiteres in der Erfindung verwendbares ferroelektrisches Flipflop mit NAND-Gattern;
- Figur 5: zeigt einen weniger abstrakten Schaltplan des in Figur 3 dargestellten ferroelektrischen Flipflops zum Einsatz in der vorliegenden Erfindung;
- Figur 6: zeigt ein ferroelektrisches Flipflop, das durch zusätzliche Logikgatter flankengesteuert ist und einen Dividierer bildet;
- Figur 7: zeigt eine Zählerschaltung mit den in Figur 6 gezeigten flankengesteuerten Flipflops;
- Figuren 8A und 8B: zeigen einen beispielhaften zeitlichen Verlauf der Kontroll- und Informationssignale sowie der Spannungsversorgung bei einer erfindungsgemäßen elektronischen Schaltung.

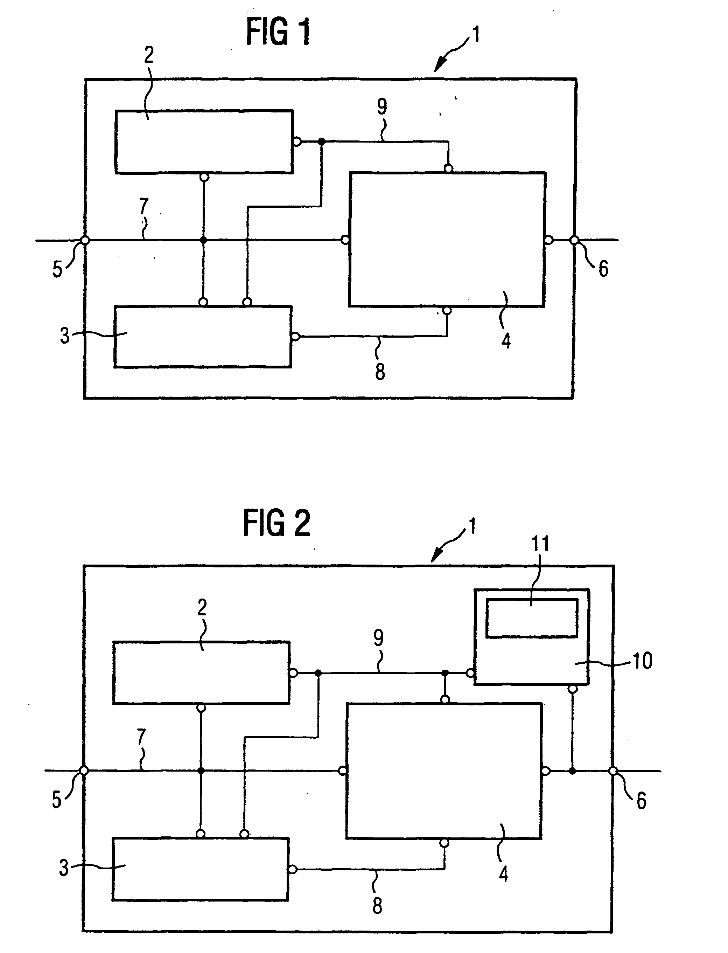

Figur 1 zeigt die schematisierte Darstellung einer möglichen Ausführungsform einer elektronischen Schaltung gemäß der vorliegenden Erfindung. Die elektronische Schaltung 1 weist zunächst einen Eingang 5 auf, über den mittels einer Signalleitung ein Informationssignal in die elektronische Schaltung 1 gelangen kann. Das Informationssignal wird auf einem Signalverteiler 7 den verschiedenen Funktionseinheiten zugeführt. Ein Energiemittel 2 erhält das Informationssignal, um daraus eine Spannungsversorgung, gegebenenfalls sogar mit mehreren unterschiedlichen Spannungen, je nach den Bedürfnissen der elektronischen Schaltung 1, erzeugen zu können.

Ein Kontrollmittel 3 erhält ebenfalls das Informationssignal, um so in die Lage versetzt zu werden, in zeitlich gesteuerter Abfolge Kontrollsignale beziehungsweise zumindest ein Kontrollsignal produzieren zu können.

Die für die Spannungsversorgung und die verschiedenen Kontrollsignale verwendeten Spannungen bemessen sich nach der Art des verwendeten Schaltungslayouts und der zum Einsatz kommenden Bauelemente, jedoch ebenfalls nach der Spannung, die die eingehenden Informationssignale aufweisen. Diese bestimmt sich typischerweise aus der Spannung, die von einem Sensor oder etwas ähnlichem, der die Informationssignale generiert, erzeugt wird.

Während bei der Darstellung in Figur 1 Energiemittel 2 und Kontrollmittel 3 als getrennte Einheiten dargestellt sind, ist es genauso möglich, beide Mittel zu einer funktionellen und operativen Einheit zusammenzufassen. Tatsächlich wird aus Vereinfachungs- und Kostenersparnisgründen in der Praxis häufig lediglich eine einzige Schaltung verwendet werden, die sowohl in der Lage ist, eine Spannungsversorgung zu generieren als auch geeignete Kontrollsignale zu erzeugen.

Die vom Energiemittel 2 zur Verfügung gestellte Spannungsversorgung wird über den Spannungsversorgungsbus 9 sowohl dem Kontrollmittel 3 als auch dem Signalverarbeitungsmittel 4 zugeführt. Dieses erhält darüber hinaus das Informationssignal über den Signalverteiler 7 sowie beim Eintreffen eines Informationssignals ebenfalls das Kontrollsignal über zumindest eine Kontrollsignalleitung beziehungsweise einen Kontrollsignalbus 8. Das Grundprinzip der erfindungsgemäßen Schaltung liegt also darin, daß das Informationssignal, das am Eingang 5 eingegangen ist, aufgesplittet und verschiedenen Verwendungen zugeführt wird. Zum einen wird ein Teil der darin enthaltenen Energie verwendet für eine Spannungsversorgung, zum anderen wird auch der Zeitpunkt des Eintreffens verwendet, um Kontrollsignale zum Aktivieren und Deaktivieren der eigentlichen Auswerteeinheit zur Verfügung zu stellen, und schließlich wird das Informationssignal der eigentlichen Signalverarbeitungseinheit zugeführt, wo es entweder nur gespeichert oder ausgewertet und dann beispielsweise im Falle eines Stromausfalls oder nach einem Zeitablauf in den ferroelektrischen Flipflops gespeichert wird. Das Signalverarbeitungsmittel 4 kann unterschiedlichste Arten der Verarbeitung beziehungsweise der Auswertung von Informationssignalen zur Verfügung stellen. Typische Anwendungen umfassen verschiedenste Arten von Zählern, wie beispielsweise asynchrone oder synchrone Dualzähler, Zähler mit umschaltbaren Zählvorrichtung, Zähler mit Vorwärts- und Rückwärtseingang, BCD-Zähler und Vorwahlzähler und auch Schieberegister. Auch andere Verschaltungslogiken können realisiert werden, beispielsweise solche, bei denen mehr als ein Informationssignal gleichzeitig eingeht und bei denen logische Verknüpfungen zwischen den Informationssignalen hergestellt werden, deren Ergebnis schließlich in einem ferroelektrischen Flipflop, auch bei Stromausfall, gespeichert werden kann.

Voraussetzung für den Betrieb der erfindungsgemäßen elektronischen Schaltung 1 ist, daß die am Eingang 6 eingehenden Informationssignale einen hinreichenden Energieinhalt aufweisen, um die elektronische Schaltung 1 mit Energie versorgen zu können. Solche Energiemengen, die in der Größenordnung zwischen 10 und 100 nJ liegen, werden beispielsweise von aktiven Wandlern wie beispielsweise induktiven oder piezoelektrischen Sensoren geliefert. Da somit genügend Energie zur Verfügung steht, wird zumindest für den eigentlichen Zählvorgang keine zusätzliche Spannungsversorgung mehr benötigt.

In Figur 1 ist ebenfalls ein Signalausgang dargestellt, durch den die in den ferroelektrischen Flipflops gespeicherte Information beziehungsweise bei andauerndem Betrieb die jeweils aktuell an den Logikgattern anliegende Information der ferroelektrischen Flipflops ausgelesen werden kann. Im einfachsten Fall handelt es sich um eine einzelne Signalleitung, die am Ausgang 6 herausgeführt ist. Wenn nur eine binäre Darstellung, also 1 beziehungsweise 0, als Information in den ferroelektrischen Flipflops gespeichert ist, reicht es aus, diese einfach auszulesen. Wenn jedoch mittels mehrerer ferroelektrischer Flipflops mehrere Bit-Informationen im Signalverarbeitungsmittel 4 zwischengespeichert sind, kann es notwendig sein, entweder mehrere Signalleitungen nach außen zu führen, die die Ausgänge der verschiedenen ferroelektrischen Flipflops gleichzeitig nach außen geben oder eine zusätzliche Schaltung bereitstellen, die in einer zeitlichen Abfolge die einzelnen Bits der verschiedenen ferroelektrischen Flipflops nacheinander über den Ausgang 6 ausgeben kann.

Figur 2 zeigt eine Modifikation eines weiteren Ausführungsbeispiels einer elektronischen Schaltung gemäß der vorliegenden Erfindung, bei der gegenüber Figur 1 noch ein Anzeigenmittel 10 mit beispielsweise einer LCD-Anzeige 11 hinzugekommen ist. Im in der Figur 2 dargestellten Ausführungsbeispiel wird das Anzeigenmittel 10 vom Spannungsversorgungsbus 9 ebenfalls mit Energie versorgt und werden die in den ferroelektrischen Flipflops des Signalverarbeitungsmittels gespeicherten Informationen ebenfalls an das Anzeigenmittel 10 ausgegeben. Hierbei kann das Anzeigenmittel 10 entweder direkt mit den Ausgängen der ferroelektrischen Flip-flops verbunden sein oder, wie in Figur 2 dargestellt, von der gleichen Ausgangssignalleitung mit bedient werden, die auch am Ausgang 6 Informationen liefert.

Im folgenden sollen die in der erfindungsgemäßen elektronischen Schaltung sowie in dem erfindungsgemäßen Verfahren verwendeten ferroelektrischen Flipflops näher beschrieben werden.

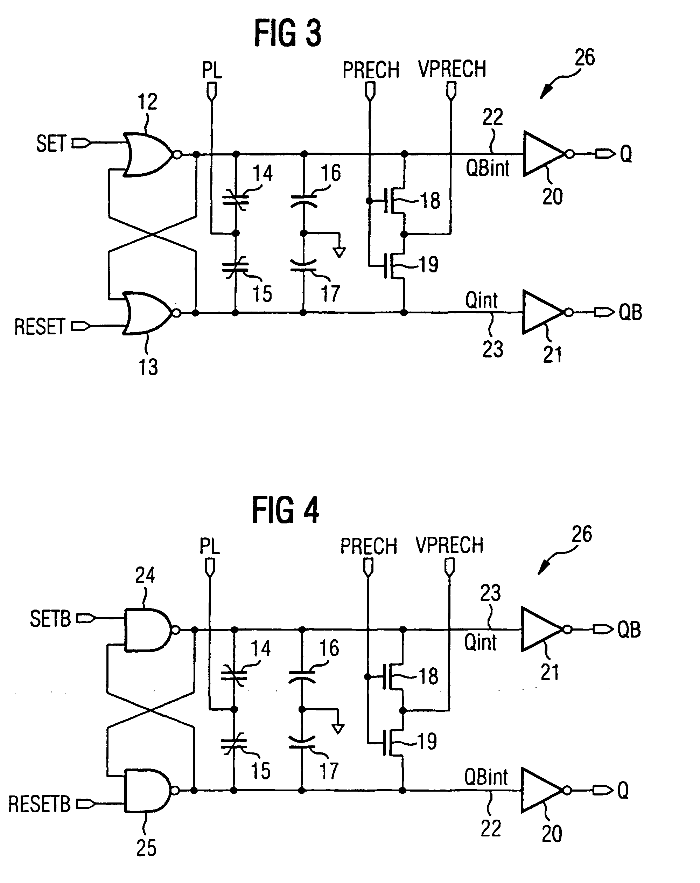

Figur 3 zeigt in schematisierter Darstellung ein ferroelektrisches Flipflop. Dieses weist die bei herkömmlichen Flip-flops bekannten Elemente auf, insbesondere zwei Logikgatter, hier NOR-Gatter 12, 13, die über jeweils einen Eingang SET beziehungsweise RESET angesteuert werden können, sowie zwei Inverter 20, 21, die über interne Datenleitungen QBint 22 und Qint 23 mit den NOR-Gattern 12, 13 verbunden sind und die invertierten Ergebnisse der Logikgatter über die Ausgänge Q beziehungsweise QB ausgeben können. Über diesen bekannten Aufbau hinausgehend weisen ferroelektrische Flipflops jedoch weitere spezifische Elemente auf. Diese sind zum einen die charakteristischen ferroelektrischen Kondensatoren 14, 15, die über eine Leitung PL mit Spannung versorgt werden können. Hinzu kommen die Vorladungstransistoren 18, 19, welche über die Leitung PRECH aktiviert werden können und über die Leitung VPRECH mit Spannung versorgt werden können. Optional können die weiteren Kapazitäten 16, 17 vorgesehen sein. Die NOR-Gatter der beiden Schaltungen sind symmetrisch ausgelegt, so daß der Zustand, der beim Einschalten eingenommen wird, von der Ladung an den Netzen Qint 23 und QBint 22 abhängt, wenn die Eingänge SET und RESET zu diesem Zeitpunkt nicht aktiv sind. Die Ladung an den Netzen Qint 23 und QBint 22 wird vor dem Einschalten der Logikgatter aus den Ferrokondensatoren 14, 15 ausgelesen und entspricht dem zuletzt eingenommenen Zustand des Flipflops vor dem letzten Ausschalten. Das Auslesen der ferroelektrischen Kondensatoren erfolgt nach dem im folgenden skizzierten Schema.

Zuerst werden die internen Datenleitungen 22, 23 über die Vorladungstransistatoren 18, 19 und das zugehörige Steuersignal PRECH auf eine bestimmte Spannung VPRECH, beispielsweise 0 Volt, vorgeladen. Um dies zu erreichen dürfen die NOR-Gatter noch nicht mit Betriebsspannung versorgt werden. Danach werden die Transistoren 18, 19 wieder abgeschaltet. Dadurch sind die Netze Qint 23 und QBint 22 hochohmig.

Nun wird Signal PL, das bis jetzt auf gleichem Potential wie VPRECH gehalten wurde, auf eine bestimmte Spannung hochgefahren. Durch die kapazitiven Spannungsteiler, die sich aus den ferroelektrischen Kondensatoren und den Kapazitäten 16, 17 der Netze Qint 23 und QBint 22 ergeben, erfolgt nun ein Ladungsausgleich. Die Kapazitäten 16, 17 können entweder nur aus Bauteileeingangs- oder Verdrahtungskapazitäten bestehen oder zusätzlich um tatsächlich realisierte Kapazitäten vergrößert werden. Um sicherzustellen, daß der Wert dieser Kapazitäten unabhängig von der Beschaltung am Ausgang der ferroelektrischen Flipflops ist, sind die internen Datenleitungen Qint 23 und QBint 22 durch zwei Inverter 20, 21 von den eigentlichen Ausgängen der Schaltung Q und QB abgekoppelt. Ist jedoch das Schaltwerk, in dem das ferroelektrische Flipflop eingesetzt wird, bekannt, können die Ausgangsinverter eventuell weggelassen werden. Je nach eingespeichertem Zustand der ferroelektrischen Kondensatoren ist nun das Potential der einen internen Datenleitung (Qint 23 oder QBint 22) nach dem Ladungsausgleich größer als das Potential der anderen Datenleitungen. Das Potential des Eingangs PL kann nun entweder auf dem höheren Potential gehalten werden oder wieder auf VPRECH verringert werden.

Nun wird die Spannungsversorgung der NOR-Gatter eingeschaltet, so daß das Flipflop in einen der beiden möglichen Zustände einrastet, je nachdem welche Spannungen an den internen Datenleitungen Qint 23 und QBint 22 anliegen. Wichtig dabei ist, daß die Eingänge der NOR-Gattern weiterhin nicht aktiv sind, daß heißt, daß SET und RESET auf Logisch LOW sein müssen. Nach dem Einschalten und Ausschalten dieses Vorgangs können die ferroelektrischen Flipflops wie gewöhnliche Flip-flops betrieben werden.

Figur 4 zeigt ein weiteres ferroelektrisches Flipflop zur Verwendung in der vorliegenden Erfindung, das dem in Figur 3 gezeigten Flipflop entspricht, jedoch anstelle der NOR-Gatter 12, 13 NAND-Gatter 24, 25 verwendet. Die internen Datenleitungen sind dementsprechend getauscht.

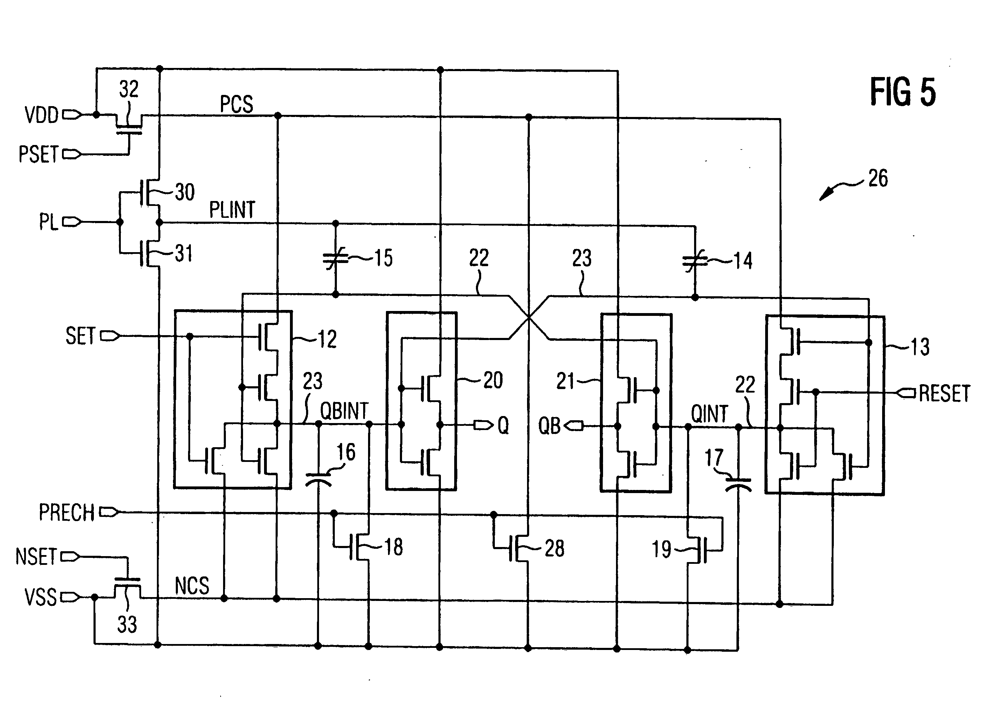

Figur 5 zeigt in einer konkreter ausgestalteten, nur noch leicht schematisierten Darstellung eine konkretere Ausführungsform des in Figur 3 allgemein gezeigten ferroelektrischen Flipflops zur Verwendung mit der vorliegenden Erfindung. Die beiden NOR-Gatter 12, 13 sowie die beiden Inverter 20, 21 sind hier mit ihren jeweils zum Einsatz kommenden Transistoren gezeichnet.

Im folgenden wird beschrieben, wie das in Figur 5 dargestellte ferroelektrische Flipflop betriebsbereit gemacht wird. Zunächst werden die beiden Vorladungstransistoren 18, 19 über das Signal PRECH aktiviert. Danach wird die Spannungsversorgung VDD auf einen geeigneten Wert, beispielsweise 3 Volt, hochgefahren. Nunmehr werden die Vorladungstransistoren 18, 19 abgeschaltet und die Spannung am Eingang PL auf einen VDD entsprechenden Wert, beispielsweise 3 Volt erhöht, so daß die beiden Übertragungsschalttransistoren 30, 31 aktiviert werden, was dazu führt, daß die in den ferroelektrischen Kondensatoren 14, 15 enthaltene Information auf die internen Datenleitungen 22, 23 transferiert wird. Zu diesem Zeitpunkt sind also die ferroelektrischen Kondensatoren sowie die Inverter mit Strom versorgt. Erst danach wird die Versorgungsspannung der beiden NOR-Gatter 12, 13 eingeschaltet, indem die Signale NSET und PSET auf die verwendete Spannung, beispielsweise 3 Volt, hochgefahren wird, was dazu führt, daß die beiden Logikschalttransistoren 32, 33 aktiviert werden und dann eine Spannung zwischen VDD und VSS an den Transistoren anliegt.

Die Figur 5 zeigt weiterhin einen Transistor für die Logikgatter 28, der die positive Spannungsversorgung der NOR-Gatter 12, 13 auf ein festes Potential VSS zieht, wenn am Signal PRECH eine Spannung angelegt wird.

Die Deaktivierung des in Figur 5 gezeigten ferroelektrischen Flipflops erfolgt in umgekehrter Reihenfolge. Zuerst wird das Signal PL abgeschaltet. Daraufhin erfolgt das Abschalten der Spannungsversorgung der NOR-Gatter 12, 13 durch Abschalten von NSET. Danach werden die Vorladungstransistoren 18, 19 durch ein Signal an PRECH aktiviert, um Störimpulse an den ferroelektrischen Kondensatoren zu vermeiden. Schließlich wird die Versorgungsspannung als solche abgeschaltet und zuletzt das Signal PRECH der Vorladungstransistoren 18, 19.

Die zuvor geschilderten ferroelektrischen Flipflops können in den elektronischen Schaltungen gemäß der vorliegenden Erfindung beziehungsweise im Verfahren der vorliegenden Erfindung in mannigfaltiger Weise eingesetzt werden. Im folgenden soll eine konkrete Anwendung beschrieben werden, mit der ein aus mehreren hintereinander geschalteten ferroelektrischen Flipflops bestehender Zähler realisiert wird. Es versteht sich jedoch, daß auch andere Schaltungsanordnungen im Rahmen der vorliegenden Erfindung realisiert werden können, beispielsweise solche, bei denen mehrere eingehende Informationssignale gleichzeitig miteinander in bestimmter Art und Weise miteinander verknüpft werden können.

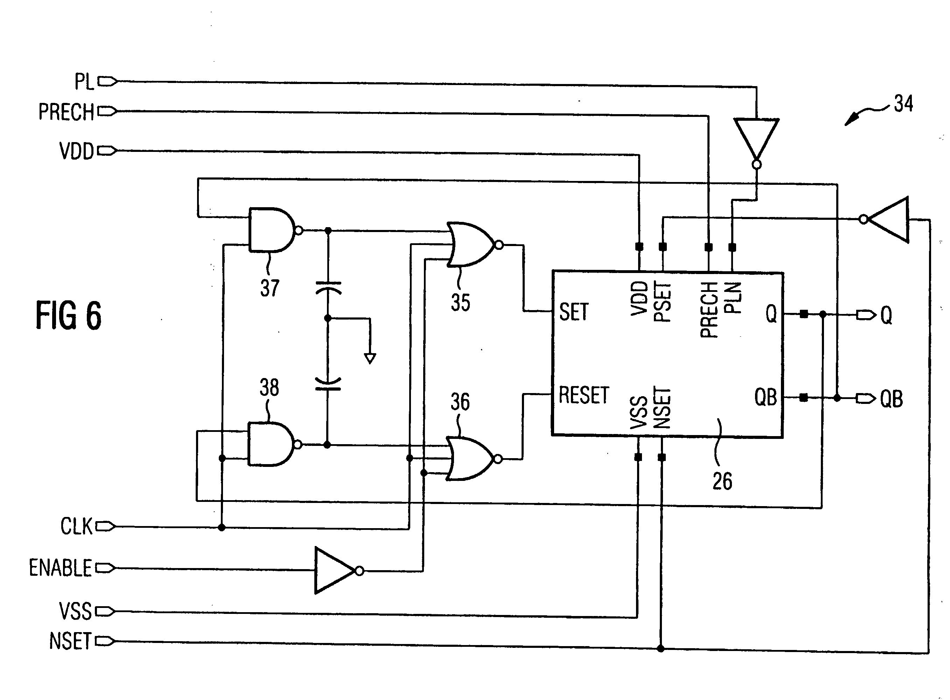

Figur 6 zeigt zunächst, wie ein ferroelektrisches Flipflop 26, wie in Figur 5 dargestellt, mit einer zusätzlichen Logikschaltung versehen wird, um daraus ein flankengesteuertes Flipflop zu machen, das zugleich eine Dividierfunktion erfüllt, das heißt bei jeder fallenden Flanke eines Informationssignals den Zustand an einem der Ausgänge Q, QB ändert. Die Schaltung 34 stellt eine Dividiereinheit da, die jedoch gleichzeitig eine spezielle Ausprägung eines Flipflops darstellt, wie dem Fachmann bekannt ist.

Jeweils zwei NOR-Gatter 35, 36 und zwei NAND-Gatter 37, 38 sind mit einem mit CLK bezeichneten Eingang für das Informationssignal verbunden. Die Bezeichnung CLK zeigt daher, daß es sich hierbei um ein auch taktsteuerbares Flipflop handelt, bei dem dann ein Taktsignal (CLOCK) an diesem Eingang angelegt werden kann. Die beiden bereits aus Figur 5 bekannten Eingänge NSET und PSET des ferroelektrischen Flipflops 26 werden in der Schaltungsanordnung der Figur 6 über einen Inverter zusammengefaßt, so daß beide von einem gemeinsamen Eingangssignal, das wiederum als NSET bezeichnet wird, angesteuert werden. In der Schaltungsanordnung der Figur 6 ist ein weiterer Eingang ENABLE vorgesehen, der aktiviert sein muß, damit ein am Eingang CLK eintreffendes Informationssignal von den NOR-Gattern 35, 36 weitergereicht wird an die Eingänge SET beziehungsweise RESET des ferroelektrischen Flipflops 26.

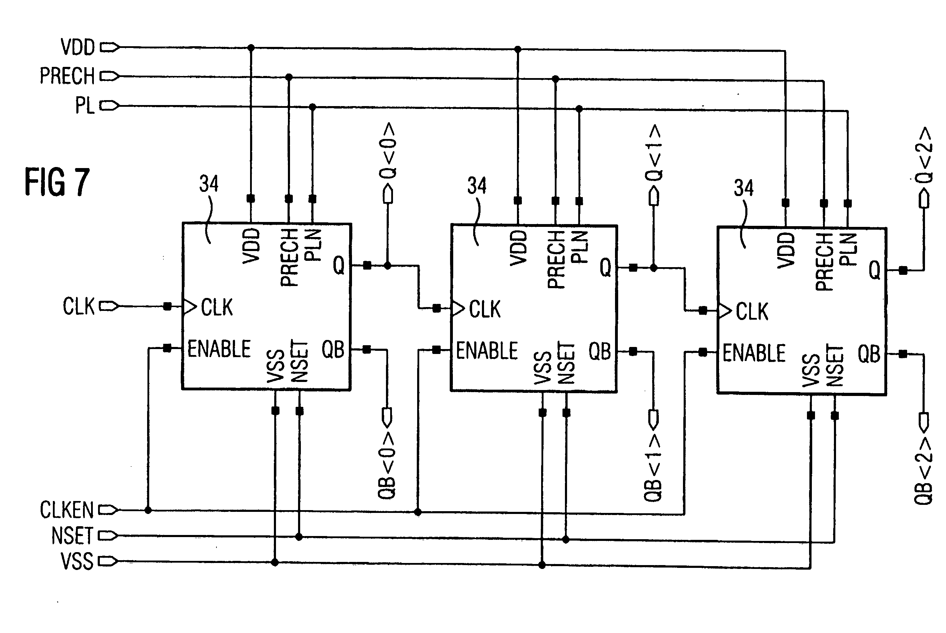

Figur 7 zeigt schließlich die Integration mehrerer dieser Dividiervorrichtungen 34 in einer Zähleranordnung. Wie hier erkennbar ist, wird das über den Eingang CLK eingehende Informationssignal lediglich an die erste Dividierschaltung 34 in der Abfolge von Dividierschaltungen eingespeist. Der Ausgang Q des ferroelektrischen Flipflops ist weitergeführt zum Eingang CLK des nächsten ferroelektrischen Flipflops beziehungsweise der nächsten Dividiereinheit 34. Die Leitungen für die Kontrollsignale PRECH, PL, NSET und schließlich das in Figur 6 hinzugekommene ENABLE (Eingang ist hier CLKEN) entsprechen den Abbildungen 5 und 6.

Jeweils mit der Flanke eines an CLK eingehenden Informationssignals ändert sich der Zustand des ersten flankengesteuerten ferroelektrischen Flipflops 34. Das gleiche geschieht mit dem zweiten flankengesteuerten ferroelektrischen Flipflop 34 in der Anordnung, das am Eingang CLK Signale vom Ausgang Q des ersten flankengesteuetrten ferroelektrischen Flipflops erhält. Dies bedeutet, daß lediglich bei jedem zweiten Informationssignal der Zustand des Ausgangs Q am zweiten flankengesteuerten ferroelektrischen Flipflop 34 wechselt. Somit ist eine Zählschaltung zustandegekommen, bei der das linke flankengesteuerte ferroelektrische Flipflop das weniger signifikante Bit repräsentiert; das am weitesten rechts befindliche das höchstwertige Bit. Die Zahl der hintereinander geschalteten ferroelektrischen Flipflops bestimmt dabei die maximale Anzahl an eingehenden Informationssignalen. Bei acht hintereinander geschalteten ferroelektrischen Flipflops 34 kann beispielsweise der dezimale Zahlenbereich zwischen 0 und 255 (entsprechend 0000 0000 bis 1111 1111 binär) dargestellt werden.

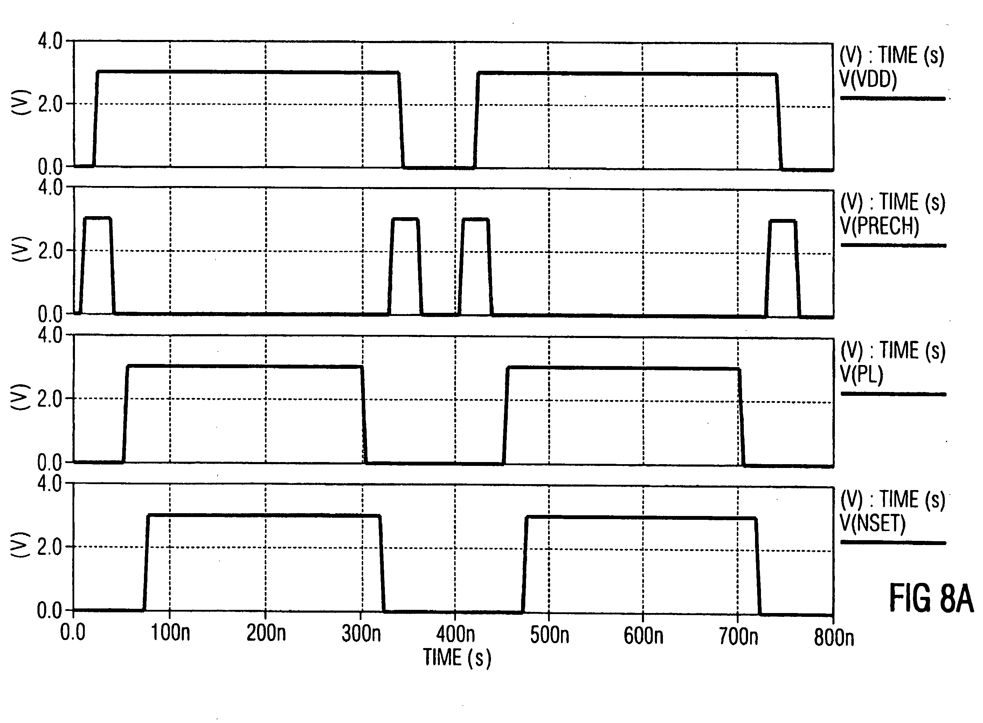

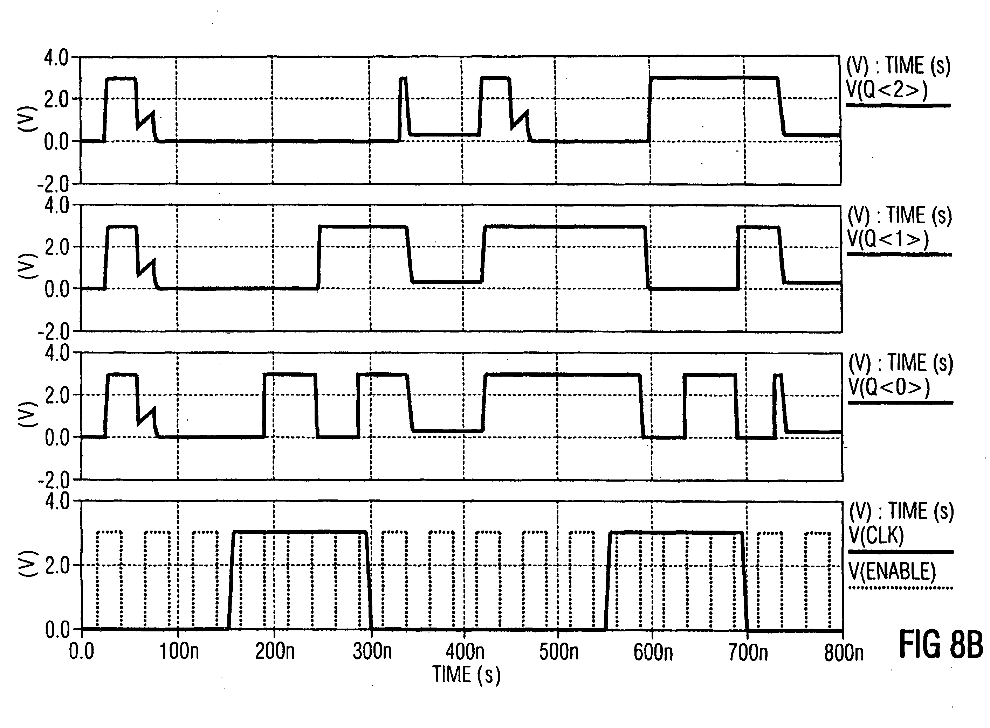

Anhand der Graphiken der Figur 8 soll nunmehr der zeitliche Ablauf eines Zählvorgangs durch die in Figur 7 gezeigte Schaltung verdeutlicht werden. In der Graphik werden zwei nacheinander ablaufende Signalerfassungszyklen gezeigt. Figur 8 zeigt den zeitlichen Verlauf der an verschiedenen Ein- bzw. Ausgängen der Schaltung anliegenden Spannungen in ihrem zeitlichen Verlauf. Auf der Abszisse ist der Zeitablauf in ns dargestellt, während auf den verschiedenen Ordinaten die jeweils anliegenden Spannungen der Signale dargestellt sind. Die Anordnung untereinander ermöglicht eine Beurteilung des zeitlichen Ablaufs der Signale zueinander.

Wie oben erläutert, wird zunächst die Spannung am Eingang PRECH angelegt, um die Vorladungstransistoren 18, 19 zu aktivieren. Das Signal PRECH wird vom Kontrollmittel 3 gebildet. Unmittelbar danach wird die Betriebsspannung VDD an das Gesamtsystem angelegt. Diese Spannung wird vom Energiemittel 2 generiert. Wie in Figur 8B dargestellt führt dies dazu, daß bei den drei, hier exemplarisch gezeigten, ferroelektrischen Flipflops 34 an den jeweiligen Ausgängen Q0 bis 2 ebenfalls eine Spannung anliegt. Unmittelbar nach Einschalten der Betriebsspannung VDD wird die Spannung am Eingang PRECH abgeschaltet.

Nunmehr erzeugt das Kontrollmittel 3 eine Spannung am Eingang PL der ferroelektrischen Flipflops, der zur Deaktivierung der Übertragungsschalttransistoren 30, 31 und damit zur Transferierung der in den ferroelektrischen Kondensatoren 14, 15 gespeicherten Informationen auf die internen Datenleitungen 22, 23 führt. Wie in Figur 8B gezeigt, nehmen zu diesem Zeitpunkt die Ausgänge der drei exemplarisch gezeigten ferroelektrischen Flipflops die definierten Pegelzustände ein, in diesem Fall also 0, da in den ferroelektrischen Flipflops 26 noch keine Informationen gespeichert sind. Im Anschluß erzeugt das Kontrollmittel 3 eine Spannung am Eingang NSET (und in einigen Ausführungsformen auch am Eingang PSET), was zur Aktivierung der Logikschalttransistoren 33 (und eventuell 32) führt, so daß die Betriebsspannung der NOR-Gatter 12, 13 beziehungsweise bei Verwendung von NAND-Gattern der NAND-Gatter 24, 25, eingeschaltet wird.

In der vorliegenden experimentellen Anwendung einer erfindungsgemäßen elektronischen Schaltung werden keine einzeln eingehenden Informationssignale verwendet. Vielmehr wird, wie in Figur 8B, unterste Linie, gezeigt, ein Takt erzeugt, der an den Eingang CLK angelegt ist. Die in den in Figur 7 zum Einsatz kommenden ferroelektrischen Flipflops beziehungsweise Dividierern 34, (siehe Figur 6) weisen einen zusätzlichen Eingang auf, der nötig ist, um eine Übertragung des an dem Eingang CLK anliegenden Informationssignals auf die Eingänge des ferroelektrischen Flipflops 26 zu ermöglichen, nämlich den Eingang ENABLE. Erst nachdem das Kontrollmittel 3 eine Spannung an den Eingang ENABLE anlegt, (siehe Figur 8B, unterste, durchgezogene Signallinie), führt das Auftreten der an den Eingang CLK angelegten Informationssignale zu einer Reaktion an den Ausgängen der ferroelektrischen Flipflops beziehungsweise Dividierer 34. Mit der fallenden Flanke des ersten nach dem Einschalten des ENABLE-Eingangs eingehenden Informationssignals ändert sich am Ausgang des ersten der hintereinander geschalteten ferroelektrischen Flipflops das Ausgangssignal von Pegel 0 auf Pegel Logisch 1. Nach Abfall des zweiten eingehenden Informationssignals ändert sich der Pegel wieder auf Logisch 0, woraufhin der Pegel am Ausgang des dahinter geschalteten ferroelektrischen Flipflops auf Logisch 1 geht. Im zeitlichen Verlauf des Versuchs wird nunmehr ein Abschaltvorgang simuliert, wie er bei einer erfindungsgemäßen elektronischen Schaltung durch das Kontrollmittel nach Ablauf einer bestimmten Zeit nach Eingehen eines letzten Informationssignals oder beim zu erwartenden Abfall der Spannungsversorgung auf Grund von Energiemangel erfolgen würde.

Im Fall des gezeigten Experiments wird dieser Abfall nur simuliert, da das Taktsignal am Eingang CLK weiter anliegt.

Zum Deaktivieren der erfindungsgemäßen ferroelektronischen Flipflops werden zunächst das ENABLE- und das PL-Signal abgeschaltet. Danach wird die Spannungsversorgung der Logikgatter abgeschaltet, indem das Signal NSET abgeschaltet wird. Dadurch wird erreicht, daß die in den drei ferroelektrischen Flipflops enthaltenen Informationen richtig in die ferroelektrischen Kondensatoren zurückgeschrieben werden. Nun werden kurzzeitig die Vorladungstransistoren 18, 19 aktiviert, die Gesamtspannungsversorgung abgeschaltet und zuletzt die Vorladungstransistoren deaktiviert.

Im Anschluß wird in dem Experiment ein weiterer Signalerfassungszyklus eingeleitet. Der Ablauf entspricht dem oben beschriebenen ersten Aktivieren der elektronischen Schaltung. Wie in Figur 8B gezeigt, werden allerdings die in den ferroelektrischen Kondensatoren 14, 15 gespeicherten Informationen der einzelnen ferroelektrischen Flipflops in die Logikgatter zurückschrieben, so daß sich, entsprechend dem Zustand vor dem letzten Abschalten an den Ausgängen des ersten und zweiten der Reihe von ferroelektrischen Flipflops ein Pegel von Logisch 1 einstellt. Die von den drei ferroelektrischen Flipflops repräsentierte Information entspricht somit dem Binärwert 011, das heißt einen Dezimalzahlenwert von 3. Nach wiederum Einschalten des ENABLE-Signals werden wieder drei Informationssignale gezählt, so daß am Ende dieser Informationssignalerfassungsphase die drei ferroelektrischen Flipflops den Binärwert 110 (entsprechend dem Dezimalzahlenwert 6) enthalten. Schließlich ist in Figur 8 noch eine weitere Deaktivierungssequenz gezeigt, die wiederum dazu führt, daß diese an den Ausgängen der ferroelektrischen Flipflops 26 anliegenden Informationen in die jeweiligen ferroelektrischen Kondensatoren 14, 15 transferiert werden.

Mit dem in Figur 8 gezeigten experimentellen Signalerfassungsvorgang konnte gezeigt werden, daß es mit der erfindungsgemäßen elektronischen Schaltung tatsächlich möglich ist, die in den ferroelektrischen Flipflops enthaltenen Informationen zwischenzuspeichern und beim Wiederauftreten von Signalen beziehungsweise von Spannung wiederherzustellen.

## Patentansprüche

1. Elektronische Schaltung (1), aufweisend
einen Eingang (5) zur Eingabe von zumindest einem Informationssignal;
ein Energiemittel (2) zur Umwandlung von im zumindest einen Informationssignal enthaltener Energie in eine Spannungsversorgung;
ein Kontrollmittel (3) zur Erzeugung zumindest eines Einschaltkontrollsignals beim Eingehen eines Informationssignals; sowie
ein Signalverarbeitungsmittel (4) zur Speicherung einer durch das zumindest eine Informationssignal repräsentierten Information mittels zumindest eines ferroelektrischen Flipflops (26) und/oder zur Auswertung einer durch das zumindest eine Informationssignal repräsentierten Information und Speicherung der durch die Auswertung erhaltenen Sekundärinformation mittels zumindest eines ferroelektrischen Flipflops (26);
wobei das Signalverarbeitungsmittel (4) durch das zumindest eine Einschältkoritrollsignal zur Auswertung und/oder Speicherung aktivierbar ist;
und wobei während der Auswertung und/oder Speicherung das zumindest eine Informationssignal die einzige Energiequelle für die elektronische Schaltung (1) sein kann oder ist;
wobei das zumindest eine Einschaltkontrollsignal folgende Signale aufweist:
ein Aktivierungssignal (PRECH) zur Aktivierung von Vorladungstransistoren (18, 19) des zumindest einen ferroelektrischen Flipflops (26);
ein Übertragungssignal (PLN) zur Übertragung der in ferroelektrischen Kondensatoren (14, 15) des zumindest einen ferroelektrischen Flipflops (26) enthaltenen Information auf interne Datenleitungen (22, 23) des zumindest einen ferroelektrischen Flipflops (26); und
ein Stromschaltsignal (NSET) zum Einschalten der Spannungsversorgung des Signalverarbeitungsmittels (4).

2. Elektronische Schaltung (1) nach Anspruch 1, **dadurch gekennzeichnet, dass** durch das Kontrollmittel (3) zumindest ein Ausschaltkontrollsignal nach Ablauf einer vorbestimmten Zeit nach Eingehen des zumindest einen Informationssignals und/oder bei Erschöpfung der aus dem zumindest einen Informationssignal umgewandelten Energie erzeugbar ist,
wobei das Signalverarbeitungsmittel (4) durch das zumindest eine Ausschaltkontrollsignal zur Speicherung und zum Deaktivieren veranlassbar ist oder veranlasst wird.

3. Elektronische Schaltung (1) nach Anspruch 1 oder 2, **dadurch gekennzeichnet, dass** die in dem zumindest einen ferroelektrischen Flipflop (26) gespeicherte Information durch das Signalverarbeitungsmittel (4) in zumindest ein Ausgangssignal umwandelbar ist und die elektronische Schaltung (1) weiterhin zumindest einen Ausgang (6) zur Ausgabe des zumindest einen Ausgangssignals aufweist.

4. Elektronische Schaltung (1) nach einem der Ansprüche 1 bis 3, **dadurch gekennzeichnet, dass** die elektronische Schaltung weiterhin ein Anzeigemittel (10) zur Anzeige der in dem zumindest einen ferroelektrischen Flipflop (26) gespeicherten Information aufweist.

5. Elektronische Schaltung (1) nach Anspruch 4, **dadurch gekennzeichnet, dass** das Anzeigemittel (10) von der durch das Energiemittel (2) erzeugten Spannungsversorgung mitversorgt ist.

6. Elektronische Schaltung (1) nach Anspruch 4 oder 5, **dadurch gekennzeichnet, dass** das Anzeigemittel (10) eine LCD-Anzeige (11) aufweist.

7. Elektronische Schaltung (1) nach einem der Ansprüche 3 bis 6, **dadurch gekennzeichnet, dass** zum Ausgeben der in dem zumindest einen ferroelektrischen Flipflop (26) gespeicherten Information durch das Signalverarbeitungsmittel (4) eine externe Spannungsversorgung und externe Kontrollmittel anschließbar sind.

8. Elektronische Schaltung (1) nach einem der Ansprüche 2 bis 7, **dadurch gekennzeichnet, dass** das zumindest eine Ausschaltkontrollsignal folgende Signale aufweist:
ein Übertragungsendesignal (PLN);
ein Aktivierungssignal (PRECH) zur Aktivierung von Vorladungstransistoren (18, 19) des zumindest einen ferroelektrischen Flipflops (26); und
ein Stromausschaltsignal (NSET) zum Ausschalten der Spannungsversorgung des Signalverarbeitungsmittels (4).

9. Elektronische Schaltung (1) nach einem der Ansprüche 1 bis 8, **dadurch gekennzeichnet, dass** vom Kontrollmittel (3) Signalleitungen (8) für jedes der Einschaltsignale zum Signalverarbeitungsmittel (4) führen.

10. Elektronische Schaltung (1) nach Anspruch 8 oder 9, **dadurch gekennzeichnet, dass** vom Kontrollmittel (3) Signalleitungen (8) für jedes der Ausschaltsignale zum Signalverarbeitungsmittel (4) führen.

11. Elektronische Schaltung (1) nach Anspruch 10, **dadurch gekennzeichnet, dass** für das Übertragungssignal und das Übertragungsendesignal eine gemeinsame Übertragungssignalleitung vom Kontrollmittel (3) zum Signalverarbeitungsmittel (4) führt, das Übertragungssignal im Anlegen einer Spannung an die gemeinsame Übertragungsignalleitung besteht und das Übertragungssendesignal im Abschalten der Spannung an der gemeinsamen Übertragungssignalleitung besteht.

12. Elektronische Schaltung (1) nach Anspruch 10 oder 11, **dadurch gekennzeichnet, dass** für das Stromschaltsignal und das Stromausschaltsignal eine gemeinsame Stromsignalleitung vom Kontrollmittel (3) zum Signalverarbeitungsmittel (4) führt, das Stromschaltsignal im Anlegen einer Spannung an die gemeinsame Stromsignalleitung besteht und das Stromausschaltsignal im Abschalten der Spannung an der gemeinsamen Stromsignalleitung besteht.

13. Elektronische Schaltung (1) nach einem der Ansprüche 1 bis 12, **dadurch gekennzeichnet, dass** die Signalverarbeitungsschaltung (4) eine Zählschaltung zur Auswertung einer Mehrzahl von hintereinander oder gleichzeitig eingehenden Informationssignalen durch Zählung der eingegangenen Informationssignale ist.

14. Elektronische Schaltung (1) nach Anspruch 13, **dadurch gekennzeichnet, dass** die Zählschaltung aus einer Mehrzahl von hintereinandergeschalteten, flankengesteuerten ferroelektrischen Flipflops (34) besteht, bei denen das zumindest eine Informationssignal in den Takteingang (CLK) des ersten ferroelektrischen Flipflops (34) der Mehrzahl von hintereinandergeschalteten ferroelektrischen Flipflops (34) eingegeben ist und der Ausgang (Q) von jedem der ferroelektrischen Flipflops (34) bis auf das letzte jeweils auch mit dem Takteingang (CLK) des dahintergeschalteten ferroelektrischen Flipflops (34) verbunden ist.

15. Verfahren zur Speicherung von durch zumindest ein Informationssignal repräsentierter Information oder durch eine Auswertung des zumindest einen Informationssignals erhaltener Information in zumindest einem ferroelektrischen Flipflop in einem Signalverarbeitungsmittel mit folgenden Schritten:
A: Erzeugen zumindest eines Einschaltkontrollsignals aus einem eingegangenen Informationssignal und Erzeugen einer Spannungsversorgung aus im zumindest einen Informationssignal enthaltener Energie;
B: Aktivieren des Signalverarbeitungsmittels (4) durch das Einschaltkontrollsignal und Anlegen der Spannungsversorgung an das Signalverarbeitungsmittel (4);
B1: Aktivieren von Vorladungstransistoren (18, 19) des zumindest einen ferroelektrischen Flipflops (26) durch Anlegen einer Spannung;
B2: Deaktivieren der Vorladungstransistoren (18, 19) des zumindest einen ferroelektrischen Flipflops (26) durch Abschalten der Spannung;
B3: Anlegen einer Spannung an ferroelektrische Kondensatoren (14, 15) des zumindest einen ferroelektrischen Flipflops (26) zur Übertragung der in den ferroelektrischen Kondensatoren (14, 15) gespeicherten Information an Logikgatter (12, 13, 24, 25) des zumindest einen ferroelektrischen Flipflops (26); und
B4: Aktivieren der Spannungsversorgung der Logikgatter (12, 13, 24, 25) des zumindest einen ferroelektrischen Flipflops (26);
C: Speichern einer durch das zumindest eine Informationssignal repräsentierten Information mittels zumindest eines ferroelektrischen Flipflops (26) und/oder Auswerten einer durch das zumindest eine Informationssignal repräsentierten Information und Speichern der durch die Auswertung erhaltenen Sekundärinformation mittels zumindest des einen ferroelektrischen Flipflops (26);
D: Erzeugen eines Ausschaltkontrollsignals nach Ablauf einer vorbestimmten Zeit nach Eingehen des zumindest einen Informationssignals und/oder bei Erschöpfung der aus dem zumindest einen Informationssignal umgewandelten Energie; und
E: Deaktivieren des Signalverarbeitungsmittels (4) durch das Ausschaltkontrollsignal.

16. Verfahren nach Anspruch 15, **dadurch gekennzeichnet, dass** Schritt E die Teilschritte aufweist:
E1: Abschalten einer an ferroelektrischen Kondensatoren (14, 15) des zumindest einen ferroelektrischen Flipflops (26) anliegenden Spannung;
E2: Deaktivieren der Spannungsversorgung der Logikgatter (12, 13, 24, 25) des zumindest einen ferroelektrischen Flipflops (26);
E3: Aktivieren von Vorladungstransistoren (18, 19) des zumindest einen ferroelektrischen Flipflops (26) durch Anlegen einer Spannung; und
E4: Deaktivieren der Vorladungstransistoren (18, 19) des zumindest einen ferroelektrischen Flipflops (26) durch Abschalten der Spannung.

17. Verfahren nach Anspruch 15 oder 16, **dadurch gekennzeichnet, dass** die elektronische Schaltung (1) mehrere ferroelektrische Flipflops (26) enthält und das Auswerten eine Summenbildung aus dem durch das Informationssignal repräsentierten Wert und einem bereits in den ferroelektrischen Flipflops (26) gespeicherten Wert beinhaltet.

18. Verfahren nach Anspruch 17, **dadurch gekennzeichnet, dass** die Summenbildung mittels eines Zählvorgang erfolgt, bei dem die Mehrzahl von ferroelektrischen Flipflops (26) in einer Zähleranordnung hintereinandergeschaltet sind und ein eingehendes Informationssignal einen Zählerstand der Zähleranordnung um den Wert 1 erhöht oder erniedrigt.

19. Verfahren nach einem der Ansprüche 15 bis 18, **dadurch gekennzeichnet, dass** die in dem zumindest einen ferroelektrischen Flipflop (26) gespeicherte Information in zumindest ein Ausgangssignal umgewandelt und aus der elektronischen Schaltung (1) ausgegeben werden kann.

20. Flüssigkeitszähler zur Bestimmung des Durchflusses von Flüssigkeiten durch ein System, aufweisend:
einen Sensor, der in Abhängigkeit einer durch das System hindurchströmenden Flüssigkeitsmenge Informationssignale generieren kann oder generiert; und
eine elektronische Schaltung (1) nach einem der Ansprüche 1 bis 13 zur Zählung der von dem Sensor generierten Informationssignale;
wobei die Informationssignale die einzige Energiequelle für die elektronische Schaltung (1) sind.

## Claims

1. Electronic circuit (1), having
an input (5) for inputting at least one information signal;
an energy means (2) for converting energy contained in the at least one information signal into a voltage supply;
a control means (3) for generating at least one switch-on control signal when an information signal arrives; and
a signal processing means (4) for storing an information item represented by the at least one information signal and/or for evaluating an information item represented by the at least one information signal and storing the secondary information obtained through the evaluation by means of at least one ferroelectric flip-flop (26);
wherein the signal processing means (4) can be activated by the at least one switch-on control signal for the purpose of evaluation and/or storage;
and wherein, during the evaluation and/or storage, the at least one information signal may be or is the sole energy source for the electronic circuit (1);
wherein the at least one switch-on control signal has the following signals:
an activation signal (PRECH) for activating precharge transistors (18, 19) of the at least one ferroelectric flip-flop (26);
a transfer signal (PLN) for transferring the information contained in ferroelectric capacitors (14, 15) of the at least one ferroelectric flip-flop (26) onto internal data lines (22, 23) of the at least one ferroelectric flip-flop (26); and
a current switching signal (NSET) for switching on the voltage supply of the signal processing means (4).

2. The electronic circuit as claimed in claim 1, **characterized**
**in that** the control means (3) can generate at least one switch-off control signal after a predetermined time has elapsed after the at least one information signal arrives and/or when the energy converted from the at least one information signal is exhausted,
wherein the signal processing means (4) can be caused or is caused to effect a storage and to effect deactivation by the at least one switch-off control signal.

3. The electronic circuit (1) as claimed in claim 1 or 2, **characterized in that** the information stored in the at least one ferroelectric flip-flop (26) can be converted into at least one output signal by the signal processing means (4) and the electronic circuit (1) furthermore has at least one output (6) for outputting the at least one output signal.

4. The electronic circuit (1) as claimed in one of claims 1 to 3, **characterized in that** the electronic circuit furthermore has a display means (10) for displaying the information stored in the at least one ferroelectric flip-flop (26).

5. The electronic circuit (1) as claimed in claim 4, **characterized**
**in that** the display means (10) is concomitantly supplied by the voltage supply generated by the energy means (2).

6. The electronic circuit (1) as claimed in claim 4 or 5, **characterized**
**in that** the display means (10) has an LCD display (11).

7. The electronic circuit (1) as claimed in one of claims 3 to 6, **characterized**
**in that** an external voltage supply and external control means can be connected for the outputting of the information stored in the at least one ferroelectric flip-flop (26) by the signal processing means (4).

8. The electronic circuit (1) as claimed in one of claims 2 to 7, **characterized**
**in that** the at least one switch-off control signal has the following signals:
a transfer end signal (PLN);
an activation signal (PRECH) for activating precharge transistors (18, 19) of the at least one ferroelectric flip-flop (26); and
a current switch-off signal (NSET) for switching off the voltage supply of the signal processing means (4).

9. The electronic circuit (1) as claimed in one of claims 1 to 8, **characterized**
**in that** signal lines (8) for each of the switch-on signals lead from the control means (3) to the signal processing means (4).

10. The electronic circuit (1) as claimed in claim 8 or 9, **characterized**
**in that** signal lines (8) for each of the switch-off signals lead from the control means (3) to the signal processing means (4).

11. The electronic circuit (1) as claimed in claim 10, **characterized**
**in that**, for the transfer signal and the transfer end signal, a common transfer signal line leads from the control means (3) to the signal processing means (4), the transfer signal consists in the application of a voltage to the common transfer signal line and the transfer end signal consists in the disconnection of the voltage on the common transfer signal line.

12. The electronic circuit (1) as claimed in claim 10 or 11, **characterized**
**in that**, for the current switching signal and the current switch-off signal, a common current signal line leads from the control means (3) to the signal processing means (4), the current switching signal consists in the application of a voltage to the common current signal line and the current switch-off signal consists in the disconnection of the voltage on the common current signal line.

13. The electronic circuit (1) as claimed in one of claims 1 to 12, **characterized**
**in that** the signal processing circuit (4) is a counting circuit for evaluating a plurality of information signals, which arrive successively or simultaneously, by counting the information signals that have arrived.

14. The electronic circuit (1) as claimed in claim 13, **characterized**
**in that** the counting circuit comprises a plurality of cascaded edge-controlled ferroelectric flip-flops (34),
in which the at least one information signal is input into the clock input (CLK) of the first ferroelectric flip-flop (34) of the plurality of cascaded ferroelectric flip-flops (34) and the output (Q) of each of the ferroelectric flip-flops (34), except for the last, is in each case also connected to the clock input (CLK) of the ferroelectric flip-flop (34) connected downstream.

15. A method for storing information represented by at least one information signal or information obtained through evaluation of the at least one information signal in at least one ferroelectric flip-flop (26) in a signal processing means (4), having the following steps:
A: generating at least one switch-on control signal from an information signal that has arrived, and generating a voltage supply from energy contained in the at least one information signal;
B: activating the signal processing means (4) by the switch-on control signal and applying the voltage supply to the signal processing means (4);
B1: activating precharge transistors (18, 19) of the at least one ferroelectric flip-flop (26) by applying a voltage:
B2: deactivating the precharge transistors (18, 19) of the at least one ferroelectric flip-flop (26) by disconnecting the voltage;
B3: applying a voltage to ferroelectric capacitors (14, 15) of the at least one ferroelectric flip-flop (26) for transferring the information stored in the ferroelectric capacitors (14, 15) to logic gates (12, 13, 24, 25) of the at least one ferroelectric flip-flop (26); and
B4: activating the voltage supply of the logic gates (12, 13, 24, 25) of the at least one ferroelectric flip-flop (26);
C: storing an information item represented by the at least one information signal and/or evaluating an information item represented by the at least one information signal and storing the secondary information obtained through the evaluation by means of at least one ferroelectric flip-flop (26);
D: generating a switch-off control signal after a predetermined time has elapsed after the at least one information signal arrives and/or when the energy converted from the at least one information signal is exhausted; and
E: deactivating the signal processing means (4) by the switch-off control signal.

16. The method as claimed in claim 15, **characterized in that** step E has the sub-steps:
E1: disconnecting a voltage present across ferroelectric capacitors (14, 15) of the at least one ferroelectric flip-flop (26);
E2: deactivating the voltage supply of the logic gates (12, 13, 24, 25) of the at least one ferroelectric flip-flop (26);
E3: activating precharge transistors (18, 19) of the at least one ferroelectric flip-flop (26) by applying a voltage; and
E4: deactivating the precharge transistors (18, 19) of the at least one ferroelectric flip-flop (26) by disconnecting the voltage.

17. The method as claimed in claim 15 or 16, **characterized**
**in that** the electronic circuit (1) contains a plurality of ferroelectric flip-flops (26) and the evaluation comprises a summation of the value represented by the information signal and a value already stored in the ferroelectric flip-flops (26).

18. The method as claimed in claim 17, **characterized**
**in that** the summation is effected by means of a counting operation in which the plurality of ferroelectric flip-flops (26) are cascaded in a counter arrangement and an arriving information signal increments or decrements a counter reading of the counter arrangement by the value 1.

19. The method as claimed in one of claims 15 to 18, **characterized**
**in that** the information stored in the at least one ferroelectric flip-flop (26) can be converted into at least one output signal and be output from the electronic circuit (1).

20. A liquid counter for determining the flow of liquids through a system, having:
a sensor which can generate or generates information signals depending on a quantity of liquid flowing through the system; and
an electronic circuit (1) as claimed in one of claims 1 to 13 for counting the information signals generated by the sensor;
wherein the information signals are the sole energy source for the electronic circuit (1).

## Revendications

1. Circuit électronique (1) présentant
une entrée (5) pour l'entrée d'au moins un signal d'information ;
un moyen d'énergie (2) pour la conversion d'énergie incluse dans au moins un signal d'information en une alimentation en tension ;
un moyen de contrôle (3) pour la génération d'au moins un signal de contrôle d'enclenchement lors de l'arrivée d'un signal d'information ; et
un moyen de traitement de signal (4) pour la mémorisation d'une information représentée par le au moins un signal d'information au moyen d'au moins une bascule (26) ferroélectrique et/ou pour l'analyse d'une information représentée par le au moins un signal d'information et la mémorisation de l'information secondaire obtenue par l'analyse au moyen d'au moins une bascule (26) ferroélectrique ;
le moyen de traitement de signal (4) pouvant être activé par le au moins un signal de contrôle d'enclenchement pour l'analyse et/la mémorisation ;
et au moins un signal d'information pouvant être ou étant l'unique source d'énergie pour le circuit électronique (1) pendant l'analyse et/ou la mémorisation ;
le au moins un signal de contrôle d'enclenchement présentant les signaux suivants :
un signal d'activation (PRECH) pour l'activation de transistors de précharge (18, 19) de la au moins une bascule (26) ferroélectrique ;
un signal de transmission (PLN) pour la transmission de l'information contenue dans des condensateurs (14, 15) ferroélectriques de la au moins une bascule (26) ferroélectrique sur des lignes de données (22, 23) internes de la au moins une bascule (26) ferroélectrique ; et
un signal de commutation de courant (NSET) pour l'enclenchement de l'alimentation en tension du moyen de traitement de signal (4).

2. Circuit électronique (1) selon la revendication 1, **caractérisé en ce que**, par le moyen de contrôle (3), au moins un signal de contrôle de déclenchement peut être généré après l'écoulement d'un temps prédéfini suivant l'arrivée du au moins un signal d'information et/ou en cas d'épuisement de l'énergie convertie à partir du au moins un signal d'information,
le moyen de traitement de signal (4) pouvant être demandé ou étant demandé par le au moins un signal de contrôle de déclenchement pour la mémorisation et pour la désactivation.

3. Circuit électronique (1) selon la revendication 1 ou 2, **caractérisé en ce que** l'information mémorisée dans la au moins une bascule (26) ferroélectrique peut être convertie par le moyen de traitement de signal (4) en au moins un signal de sortie et le circuit électronique (1) présente également au moins une sortie (6) pour la sortie du au moins un signal de sortie.

4. Circuit électronique (1) selon l'une quelconque des revendications 1 à 3, **caractérisé en ce que** le circuit électronique présente également un moyen d'affichage (10) pour l'affichage de l'information mémorisée dans la au moins une bascule (26) ferroélectrique.

5. Circuit électronique (1) selon la revendication 4, **caractérisé en ce que** le moyen d'affichage (10) est également alimenté par l'alimentation en tension générée par le moyen d'énergie (2).

6. Circuit électronique (1) selon la revendication 4 ou 5, **caractérisé en ce que** le moyen d'affichage (10) présente un affichage à cristaux liquides (11).

7. Circuit électronique (1) selon l'une quelconque des revendications 3 à 6, **caractérisé en ce que**, pour la sortie de l'information mémorisée dans la au moins bascule (26) ferroélectrique, une alimentation en tension externe et des moyens de contrôle externes peuvent être raccordés par le moyen de traitement de signal (4).

8. Circuit électronique (1) selon l'une quelconque des revendications 2 à 7, **caractérisé en ce que** le au moins un signal de contrôle de déclenchement présente les signaux suivants :
un signal de fin de transmission (PLN);
un signal d'activation (PRECH) pour l'activation de transistors de précharge (18, 19) de la au moins une bascule (26) ferroélectrique ; et
un signal de déclenchement du courant (NSET) pour le déclenchement de l'alimentation en tension du signal de traitement de signal (4).

9. Circuit électronique (1) selon l'une quelconque des revendications 1 à 8, **caractérisé en ce que** des lignes de signalisation (8) partent du moyen de contrôle (3) pour chacun des signaux d'enclenchement au moyen de traitement de signal (4).

10. Circuit électronique (1) selon la revendication 8 ou 9, **caractérisé en ce que** des lignes de signalisation (8) partent du moyen de contrôle (3) pour chacun des signaux de déclenchement au moyen de traitement de signal (4).

11. Circuit électronique (1) selon la revendication 10, **caractérisé en ce que**, pour le signal de transmission et le signal d'émission de transmission, une ligne commune de signalisation de transmission va du moyen de contrôle (3) au moyen de traitement de signal (4), le signal de transmission consiste dans l'application d'une tension sur la ligne commune de signalisation de transmission et le signal d'émission de transmission consiste dans la déconnexion de la tension sur la ligne commune de signalisation de transmission.

12. Circuit électronique (1) selon la revendication 10 ou 11, **caractérisé en ce que**, pour le signal d'enclenchement de courant et le signal de déclenchement de courant, une ligne commune de signalisation de courant va du moyen de contrôle (3) au moyen de traitement de signal (4), le signal d'enclenchement de courant consiste dans l'application d'une tension sur la ligne commune de signalisation de courant et le signal de déclenchement de courant consiste dans la déconnexion de la tension sur la ligne commune de signalisation de courant.

13. Circuit électronique (1) selon l'une quelconque des revendications 1 à 12, **caractérisé en ce que** le circuit de traitement de signal (4) est un circuit de comptage pour l'analyse d'une pluralité de signaux d'informations entrant les uns après les autres ou simultanément par le comptage des signaux d'informations entrés.

14. Circuit électronique (1) selon la revendication 13, **caractérisé en ce que** le circuit de comptage comprend une pluralité de bascules (34) ferroélectriques, commutées les unes derrière les autres et à fonctionnement par transition, sur lesquelles le au moins un signal d'information est entré dans l'entrée de rythme (CLK) de la première bascule (34) ferroélectrique de la pluralité de bascules (34) ferroélectriques branchées les unes derrière les autres et la sortie (Q) de chacune des bascules (34) ferroélectriques à l'exception de la dernière est reliée effectivement également à l'entrée de rythme (CLK) de la bascule (34) ferroélectrique commutée derrière.

15. Procédé pour la mémorisation de l'information représentée par au moins un signal d'information ou de l'information obtenue par une analyse du au moins un signal d'information dans au moins une bascule ferroélectrique dans un moyen de traitement de signal comprenant les étapes suivantes :
A : Génération d'au moins un signal de contrôle d'enclenchement comprenant un signal d'information entré et génération d'une alimentation en tension à partir d'énergie contenue dans au moins un signal d'information ;
B : Activation du moyen de traitement de signal (4) par le signal de contrôle d'enclenchement et application de l'alimentation en tension sur le moyen de traitement de signal (4) ;
B1 : Activation de transistors de précharge (18, 19) de la au moins une bascule (26) ferroélectrique par l'application d'une tension ;
B2 : Désactivation des transistors de précharge (18, 19) de la au moins une bascule (26) ferroélectrique par déconnexion de la tension ;
B3 : Application d'une tension sur des condensateurs (14, 15) ferroélectriques de la au moins une bascule (26) ferroélectrique pour la transmission de l'information mémorisée dans les condensateurs (14, 15) ferroélectriques sur les portes logiques (12, 13, 24, 25) de la au moins une bascule (26) ferroélectrique ; et
B4 : Activation de l'alimentation en tension des portes logiques (12, 13, 24, 25) de la au moins une bascule (26) ferroélectrique;
C : Mémorisation d'une information représentée par le au moins un signal d'information au moyen d'au moins une bascule (26) ferroélectrique et/ou analyse d'une information représentée par le au moins un signal d'information et mémorisation de l'information secondaire obtenue par l'analyse au moyen d'une bascule (26) ferroélectrique ;
D : Génération d'un signal de contrôle de déclenchement après l'expiration d'un temps prédéfini suivant l'arrivée du au moins un signal d'information et/ou en cas d'épuisement de l'énergie convertie à partir du au moins un signal d'information ; et
E : Désactivation du moyen de traitement de signal (4) par le signal de contrôle de déclenchement.

16. Procédé selon la revendication 15, **caractérisé en ce que** l'étape E présente les étapes partielles suivantes :
E1 : Déconnexion d'une tension appliquée sur des condensateurs (14, 15) ferroélectriques de la au moins une bascule (26) ferroélectrique ;
E2 : Désactivation de l'alimentation en tension des portes logiques (12, 13, 24, 25) de la au moins une bascule (26) ferroélectrique ;
E3 : Activation de transistors de précharge (18, 19) de la au moins une bascule (26) ferroélectrique par l'application d'une tension ; et
E4 : Désactivation de transistors de précharge (18, 19) de la au moins une bascule (26) ferroélectrique par déconnexion de la tension.

17. Procédé selon la revendication 15 ou 16, **caractérisé en ce que** le circuit (1) électronique contient plusieurs bascules (26) ferroélectriques et l'analyse contient une totalisation constituée de la valeur représentée par le signal d'information et d'une valeur déjà mémorisée dans les bascules (26) ferroélectriques.

18. Procédé selon la revendication 17, **caractérisé en ce que** la totalisation s'effectue au moyen d'une opération de comptage, lors de laquelle la pluralité de bascules (26) ferroélectriques sont branchées les unes derrière les autres dans un dispositif compteur et un signal d'information entrant augmente ou abaisse une indication de consommation du dispositif compteur de la valeur 1.

19. Procédé selon l'une quelconque des revendications 15 à 18, **caractérisé en ce que** l'information mémorisée dans la au moins une bascule 26 ferroélectrique est convertie en au moins un signal de sortie et peut être éditée à partir du circuit (1) électronique.

20. Compteur de liquide pour déterminer le débit de liquides à travers un système, comprenant les éléments suivants :
un capteur, qui peut générer ou génère des signaux d'informations en fonction d'une quantité de liquide s'écoulant à travers le système ; et
un circuit (1) électronique selon l'une quelconque des revendications 1 à 13 pour le comptage des signaux d'informations générés par le capteur ;
les signaux d'information étant l'unique source d'énergie pour le circuit (1) électronique.
